(19) Europäisches Patentamt
European Patent Office
Office européen des brevets

(11) **EP 3 667 333 A2**

(12) **EUROPÄISCHE PATENTANMELDUNG**

(43) Veröffentlichungstag:
**17.06.2020 Patentblatt 2020/25**

(51) Int Cl.:
***G01Q 70/10*** *(2010.01)* ***G01Q 70/16*** *(2010.01)*

(21) Anmeldenummer: **19215302.1**

(22) Anmeldetag: **11.12.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **14.12.2018 DE 102018221778**

(71) Anmelder: **Carl Zeiss SMT GmbH**
**73447 Oberkochen (DE)**

(72) Erfinder:
• **BAUR, Christof**
**64285 Darmstadt (DE)**
• **KORNILOV, Kinga**
**64380 Roßdorf (DE)**

(74) Vertreter: **Wegner, Hans**
**Bardehle Pagenberg Partnerschaft mbB**
**Patentanwälte, Rechtsanwälte**
**Prinzregentenplatz 7**
**81675 München (DE)**

(54) **SONDE, SOWIE VERFAHREN, VORRICHTUNG UND COMPUTERPROGRAMM ZUR HERSTELLUNG EINER SONDE FÜR RASTERSONDENMIKROSKOPE**

(57) Die vorliegende Erfindung betrifft ein Verfahren zur Herstellung einer Sonde für ein Rastersondenmikroskop mit folgenden Schritten: teilchenstrahlinduziertes Erzeugen und / oder Bearbeiten einer Sondenspitze auf einem Substrat; wobei eine sich zeitlich verändernde Wechselwirkungsposition eines Teilchenstrahls derart kontrolliert wird, dass eine seitliche Oberfläche eines Sockelbereichs der erzeugten und / oder bearbeiteten Sondenspitze eine negative Krümmung aufweist.

**Fig. 4**

**Beschreibung**

Die vorliegende Anmeldung beansprucht die Priorität der deutschen Erstanmeldung DE 10 2018 221 778.5 eingereicht beim DPMA am 14. Dezember 2018.

## 1. Technisches Gebiet

Die vorliegende Erfindung betrifft eine Sonde, sowie Verfahren, eine Vorrichtung und ein Computerprogramm zur Herstellung einer Sonde für Rastersondenmikroskope.

## 2. Stand der Technik

Rastersondenmikroskope tasten mit einer Sondenspitze eine Probe bzw. deren Oberfläche ab und liefern damit Messdaten zum Erzeugen einer Darstellung der Topographie der Probenoberfläche. Je nach Art der Wechselwirkung zwischen der Sondenspitze und der Probenoberfläche werden verschiedene Typen von Rastersondenmikroskopen unterschieden. Häufig werden Rastertunnelmikroskope eingesetzt, bei denen zwischen der Probe und der Sondenspitze, die einander nicht berühren, eine Spannung angelegt wird und der resultierende Tunnelstrom gemessen wird. Beim Rasterkraftmikroskop wird eine Messsonde durch atomare Kräfte der Probenoberfläche, typischerweise attraktive Van-der-Waals-Kräfte und/oder repulsive Kräfte der Austauschwechselwirkung, ausgelenkt.

Das Herstellen von Sondenspitzen für Rastersondenmikroskope ist ein schwieriger und dadurch teurer Prozess. Dies ist insbesondere der Fall für sehr dünne Sondenspitzen mit einem hohen Aspektverhältnis, die für das Vermessen nanostrukturierter Proben verwendet werden. Solche Sondenspitzen werden konventionell durch teilchenstrahlinduziertes Abscheiden von einem Material auf einem Substrat erzeugt.

Beispielsweise beschreibt die Publikation "Tips for scanning tunneling microscopy produced by electron-beam-induced-deposition" B. Hübner et al.; Ultramicrsocopy 42-44 (1992) das Herstellen konusförmiger Sondenspitzen mit einem minimalen Spitzendurchmesser von 10 nm, einer maximalen Höhe von 1200 nm.

Als Substrat kommen hierbei üblicherweise sogenannte Federbalken (engl. Cantilever) zum Einsatz. Oft sind auf diesen Federbalken pyramidenförmige Standardspitzen angeordnet, auf denen die eigentliche Sondenspitze abgeschieden wird.

Die Abnutzung solcher dünnen Sondenspitzen mit einem großen Aspektverhältnis ist ein seit langem bekanntes Problem. Insbesondere brechen diese Sondenspitzen häufig ab was zu einem vollständigen Austauschen der Sonde des Rastersondenmikroskop führen kann. Zusätzlich zu den Kosten, die für den Ersatz der Sonde anfallen, führt das Austauschen der Sonde oft zu einem längeren Ausfall des Rastersondenmikroskops, was Folgekosten wie etwa einen durch die Nichtverfügbarkeit des Rastersondenmikroskops bedingten Produktionsausfall verursachen kann.

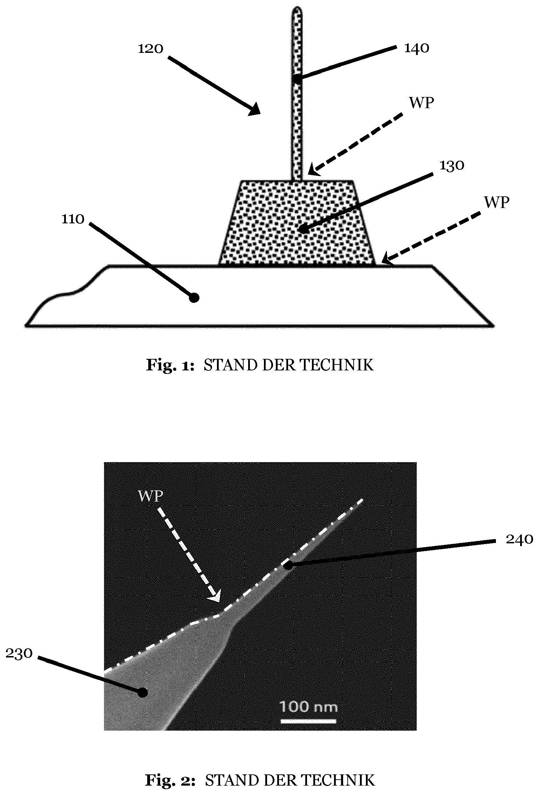

Besonders kritisch sind Anwendungen im Bereich der Reparatur von Photomasken für die Photolithographie. Produktverluste bzw. Schäden an der Photomaske durch katastrophales Versagen der Sondenspitzen sind hierbei extrem kostspielig. Deshalb müssen die Sondenspitzen nicht nur sehr hart sein, um den Verschleiß zu minimieren, sondern auch gleichzeitig robust sein, um ein komplettes Abrechen der Sondenspitze zu verhindern. Harte Materialien sind jedoch oft spröde. Sondenspitzen aus harten Materialien sind daher anfälliger für Spitzenbrüche. Schwachstellen im Spitzenaufbau müssen daher systematisch beseitigt werden, da sie die Probleme beim Brechen der Sondenspitzen verschärfen. Typische Schwachstellen sind die Befestigung der Sondenspitze am Substrat, Übergänge von einer Geometrie zu einer anderen oder ein Materialwechsel (siehe Fig. 1 und Fig. 2 unten).

Aus dem Stand der Technik sind verschiedene Verfahren zur Reduzierung der Abnutzung von Sondenspitzen von Rastersondenmikroskopen bekannt. Beispielsweise beschreibt die deutsche Patentanmeldung DE 10 2016 223 659 ein Verfahren in dem eine Sondenspitze durch Bestrahlung mit geladenen Teilchen gehärtet wird.

Zusätzlich ist aus dem Stand der Technik bekannt, die eigentliche Sondenspitze nicht direkt auf dem Substrat abzuscheiden, sondern in einem ersten Schritt einen Sockel auf dem Substrat abzuscheiden und die eigentliche Sondenspitze dann auf dem Sockel zu erzeugen (siehe Fig. 1 unten). Sockel und Sondenspitze haben dabei vorzugsweise das gleiche Material, wobei der Durchmesser des Sockels wesentlich größer ist als der Durchmesser der Sondenspitze.

Darüber hinaus ist aus dem deutschen Patent DE 198 254 04 ein Verfahren bekannt, bei dem die eigentliche Sondenspitze von einem konusförmigen Stützbereich umgeben wird. Insbesondere findet hierbei der für das Abscheiden des Spitzenmaterials notwendige Energieübertrag zwischen Elektronenstrahl und Substrat bzw. der zu erzeugenden Sondenspitze in vorbestimmten, rasterförmigen Verlaufsmuster statt, die z.B. spiralförmig sein können.

Ein weiteres Verfahren zur Reduktion der Spitzenabnutzung ist auch aus der Publikation "Direct patterning of surface quantum wells with an atomic force microscope", J. Cortes Rosa et al.; Appl. Phys. Lett., Bd. 73, Nr. 18, p. 2684 (1998) bekannt.

Die Dokumente DE 103 22 005, DE 102 009 022 912, US 7,232,997, US 6,593,583, EP 1662 538 und US 6,521,890 befassen sich ebenfalls mit verschiedenen Aspekten der Herstellung von Sonden für Rastersondenmikroskope bzw. mit verschiedenen, für die Erfindung relevanten Aspekten der Rastersondenmikroskopie.

Zusätzlich sei auf die folgenden Veröffentlichungen verwiesen:

J. H. Kindt, G. E. Fantner, J. B. Thompson und P. K. Hansma, "Automated wafer-scale fabrication of electron beam deposited tips for atomic force microscopes using pattern recognition," Nanotechnology, Bd. 15, pp. 1131-1134, 2004.

D. Freeman, B. Luther-Davies und S. Madden, "Real-Time Drift Correction of a Focused Ion Beam Milling System," in NSTI-Nanotech, 2006.

C. J. Lobo, A. Martin, M. R. Phillips und M. Toth, "Electron beam induced chemical dry etching and imaging in gaseous NH3 environments," Nanotechnology, Nr. 23, pp. 1-7,2012.

Produktdatenblatt: *"Supersharp high aspect ratio AFM tips for fine features, Type: HDC-40 / HDC-30 / HDC-20,"* nanotools GmbH, [Online]. Verfügbar unter: http://www.nanotools.com/cms/upload/productflyer/HDC-Fine-Features_2017-09-R003.pdf.

Dennoch bleibt die Reduktion der Abnutzung von dünnen Sondenspitzen eines der dringenden Probleme bei der Verbesserung der Rastersondenmikroskopie.

Weitere Probleme bei der Herstellung von Sonden für Rastersondenmikroskope mit dünnen Sondenspitzen bestehen in der Reproduzierbarkeit der Herstellung, der langen Herstellungsdauer, der schwierigen Automatisierbarkeit des Herstellungsprozesses sowie bei der Konstruktion und Herstellung von sondergefertigten, anwendungsspezifischen Sonden.

Folglich besteht ein fortwährendes Interesse daran, die aus dem Stand der Technik bekannten Sonden, deren Herstellungsverfahren sowie Vorrichtungen zur Herstellung solcher Sonden zu verbessern und dadurch die Nachteile des Stands der Technik zu beheben oder zumindest zu verringern.

### 3. Zusammenfassung der Erfindung

Die oben angeführten Probleme werden zumindest teilweise durch den Gegenstand der unabhängigen Ansprüche der vorliegenden Erfindung gelöst. Beispielhafte Ausführungsformen werden in den abhängigen Ansprüchen beschrieben.

In einer Ausführungsform stellt die vorliegende Erfindung ein Verfahren zur Herstellung einer Sonde für ein Rastersondenmikroskop bereit, wobei das Verfahren die folgenden Schritte umfasst: teilchenstrahlinduziertes Erzeugen und / oder Bearbeiten einer Sondenspitze auf einem Substrat; wobei eine Wechselwirkungsposition eines Teilchenstrahls derart kontrolliert wird, dass eine seitliche Oberfläche eines Sockelbereichs der erzeugten und / oder bearbeiteten Sondenspitze eine negative Krümmung aufweist.

Unter einer negativen Krümmung ist hierbei und im Folgenden ein negativer Wert der sogenannten *Gaußschen Krümmung* K zu verstehen. Diese ist mit den beiden sogenannten *Hauptkrümmungen* $k_1$ und $k_2$ der Oberfläche des Sockelbereichs über die Gleichung

$$K = k_1 \cdot k_2 = \frac{1}{r_1} \cdot \frac{1}{r_2}, (\text{Gl. 1})$$

verknüpft, wobei $r_1$ und $r_2$ die sogenannten *Hauptkrümmungsradien* sind.

Beispielsweise gilt für eine Kugeloberfläche $k_1 > 0$, $k_2 > 0$, K = const > 0 und für die Oberfläche eines Konus oder eines Zylinders $k_1 > 0$, $k_2 = 0$, K = o. Ein Beispiel für eine Oberfläche mit negativer Krümmung ist die sog. *Pseudosphäre* bzw. der *Traktikoid* (d.h. der Rotationskörper einer Traktrix) mit $k_1 < 0$, $k_2 > 0$ und K = const < o.

Insbesondere kann im Wesentlichen die gesamte seitliche Oberfläche des Sockelbereichs die gewünschte negative Krümmung aufweisen. Der Begriff "im *Wesentlichen"* ist hierbei und im Folgenden als *"innerhalb typischer Design-, Berechnungs-, Mess- und / oder Fertigungstoleranzen"* zu verstehen.

Hierbei kann das Erzeugen der Sondenspitze beispielsweise ein teilchenstrahlinduziertes Abscheiden zumindest eines Materials und / oder ein teilchenstrahlinduziertes Ätzen mit zumindest einem Ätzgas umfassen.

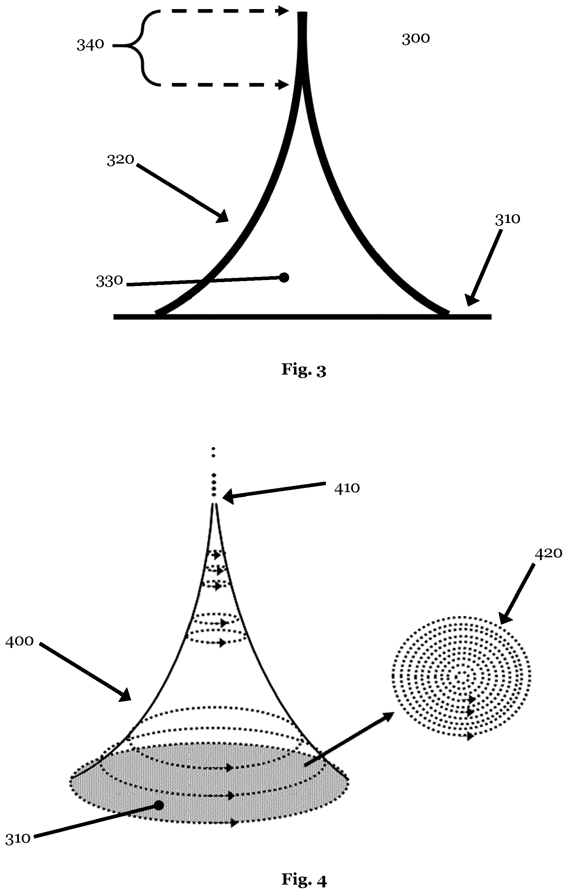

Durch das kontrollierte Erzeugen eines negativ gekrümmten Sockelbereichs kann einerseits sichergestellt werden, dass die Verbindungsfläche zwischen Substrat und Sockelbereich groß genug ist, um ein Ablösen des Sockelbereichs von dem Substrat zu unterbinden und andererseits, dass der Sockelbereich kontinuierlich und ohne wesentliche Inhomogenitäten in den oberen Bereich der Sondenspitze übergeht. Zusätzlich führt die negative Krümmung der seitlichen Oberfläche dazu, dass der mittlere Durchmesser des Sockelbereichs schnell genug abnimmt, sodass trotz einer großen Verbindungsfläche des Sockelbereichs mit dem Substrat, ein großes Aspektverhältnis der Sondenspitze gewährleistet bleibt (siehe Fig. 3 unten).

Beispielsweise kann in einigen Ausführungsformen der vorliegenden Erfindung das abgeschiedene Material aus zumindest einem Vorläufermaterial erhalten werden. Als Vorläufermaterial kommen zum Beispiel eine oder mehrere der folgenden Substanzen in Frage:

- (Metall-, Übergangselemente-, Hauptgruppen-) Alkyle wie Cyclopentadienyl (Cp)- bzw. Methylcyclopentadienyl (MeCp)- trimethyl-platin (CpPtMe3 bzw. MeCpPtMe3), Tetramethylzinn SnMe4, Trimethylgallium GaMe3, Ferrocen Cp2Fe, bis-aryl-Chrom Ar2Cr und weitere solche Verbindungen;

- (Metall-, Übergangselemente-, Hauptgruppen-) Carbonyle wie Chromhexacarbonyl Cr(CO)6, Molybdänhexacarbonyl Mo(CO)6, Wolframhexacarbonyl W(CO)6, Dicobaltoctacarbonyl Co2(CO)8, Tri-

rutheniumdodecacarbonyl Ru3(CO)12, Eisenpenta-carbonyl Fe(CO)5 und weitere solche Verbindun-gen;

- (Metall-, Übergangselemente-, Hauptgruppen-) Alk-oxyde wie Tetraethoxysilan Si(OC2H5), Tetraisopropoxytitan Ti(OC3H7)4 und weitere solche Verbin-dungen;

- (Metall-, Übergangselemente-, Hauptgruppen-) Ha-logenide wie WF6, WCl6, TiCl6, BCl3, SiCl4 und weitere solche Verbindungen;

- (Metall-, Übergangselemente-, Hauptgruppen-) Komplexe wie Kupfer-bishexafluoroacetylacetonat Cu(C5F6HO2)2, Dimethyl-goldtrifluoroacetylacetonat Me2Au(C5F3H4O2) und weitere solche Verbindungen;

- Organische Verbindungen wie CO, CO2, aliphati-sche oder aromatische Kohlenwasserstoffe, Be-standteile von Vakuum-Pumpen-Öl, volatile organische Verbindungen und weitere solche Verbindungen.

Des Weiteren kann während des Erzeugens oder Bearbeitens der Sondenspitze auf dem Substrat eines oder mehrere der folgende Zusatzgase zur Anwendung kommen:

- Oxidationsstoffe wie O2, O3, H2O, H2O2, N2O, NO, NO2, HNO3 und weitere sauerstoffhaltige Gase;

- Halogenide wie Cl2, HCl, XeF2, HF, I2, HI, Br2, HBr, NOCl, PCl3, PCl5, PF3 und weitere halogenhaltige Gase;

- Gase mit reduzierender Wirkung wie H2, NH3, CH4 und weitere wasserstoffhaltige Gase.

In weiteren Ausführungsformen der vorliegenden Erfindung kann das Verfahren zusätzlich umfassen: teilchenstrahlinduziertes Erzeugen und / oder Bearbeiten eines Whiskerbereichs oberhalb des Sockelbereichs der Sondenspitze; oder teilchenstrahlinduziertes Erzeugen und / oder Bearbeiten eines Whiskerbereichs oberhalb des Sockelbereichs der Sondenspitze und eines Mittelbereichs zwischen Sockelbereich und Whiskerbereich der Sondenspitze, wobei die seitliche Oberfläche des Mittelbereichs nicht negativ gekrümmt ist.

Beispielsweise kann der Mittelbereich die Form eines Zylinders oder eines Konus bzw. mehrere Konusse aufweisen.

In einigen Ausführungsformen wird die Wechselwirkungsposition des Teilchenstrahls dabei derart kontrolliert, dass der Sockelbereich kontinuierlich in den Whiskerbereich oder in den Mittelbereich der Sondenspitze übergeht, ohne dass die negative Krümmung der seitlichen Oberfläche der Sondenspitze positiv wird. Beispielsweise kann die Sondenspitze im Wesentlichen die Form einer Pseudosphäre haben oder die Form eines Rotationskörpers eines Kreisabschnitts (siehe Gleichung 2 unten).

Dadurch kann erreicht werden, dass die Sondenspitze keinerlei Schwachstellen aufweist wie zum Beispiel ein unstetiger Übergang zwischen Sockelbereich und Whiskerbereich oder eine Übergangsregion zwischen zwei Konusbereichen mit unterschiedlichem Grundflächendurchmesser. Insbesondere können dadurch Bereiche der Sondenspitze mit erhöhter Kerbwirkung vermieden werden und / oder die Kerbwirkung auf die gesamte Sondenspitze oder einen Teil davon kann dadurch minimiert werden. Beispielsweise kann der Radius des Sockelbereichs als Funktion der Höhe so gewählt werden, dass die Kerbwirkung im Bereich des Fußpunktes des Sockelbereichs minimiert wird. Dies kann im Allgemeinen durch eine negative Krümmung der seitlichen Sockeloberfläche erreicht werden.

Ferner kann der Whiskerbereich eine Höhe von zumindest 10 nm, bevorzugt von zumindest 50 nm, mehr bevorzugt von zumindest 100 nm, noch mehr bevorzugt von zumindest 500 nm und am meisten bevorzugt von zumindest 1000 nm aufweisen.

Ferner kann der Whiskerbereich einen mittleren Radius von höchstens 30 nm, bevorzugt von höchstens 20 nm, mehr bevorzugt von höchstens 10 nm, noch mehr bevorzugt von höchstens 5 nm und am meisten bevorzugt von höchstens 3 nm aufweisen.

Ferner kann der Sockelbereich eine Höhe von zumindest 20 nm, bevorzugt von zumindest 100 nm, mehr bevorzugt von zumindest 250 nm, noch mehr bevorzugt von zumindest 500 nm und am meisten bevorzugt von zumindest 1000 nm aufweisen.

Ferner kann dasjenige Ende des Sockelbereichs, das auf dem Substrat angeordnet ist, einen mittleren Radius von zumindest 25 nm, bevorzugt von zumindest 100 nm, mehr bevorzugt vom zumindest 300 nm, noch mehr bevorzugt von zumindest 750 nm und am meisten bevorzugt von zumindest 1500 nm aufweisen.

Ferner kann in einigen Ausführungsformen eine der Hauptkrümmungen der Oberfläche des Sockelbereichs negativ und im Wesentlichen konstant sein. Insbesondere kann die negative Hauptkrümmung der Oberfläche des Sockelbereichs zumindest 1/(1000 nm), bevorzugt zumindest 1/(500 nm), mehr bevorzugt 1/(100 nm) und am meisten bevorzugt zumindest 1/(10 nm) betragen, dabei bevorzugt jedoch höchstens den Kehrwert der Höhe des Sockelbereichs.

Durch die oben spezifizierten Abmessungen des Sockelbereichs und des Whiskerbereichs kann sichergestellt werden, dass die Abnutzung der Sondenspitze signifikant reduziert wird, ohne dass dabei das räumliche Auflösungsvermögen der Sonde beeinträchtigt wird. Insbesondere nimmt der Durchmesser des Sockelbereichs als Funktion der Höhe des Sockelbereichs schnell genug ab um ein hohes Aspektverhältnis zu erzielen, was insbesondere für die Vermessung von tiefen, nanostrukturierten Gräben essentiell ist.

In einigen Ausführungsformen der vorliegenden Erfindung kann der Whiskerbereich eine Höhe von zumindest 10 nm und höchstens 1000 nm, bevorzugt von zumindest 30 nm und höchstens 700 nm und mehr bevorzugt von zumindest 50 nm und höchstens 400 nm aufweisen.

In einigen Ausführungsformen der vorliegenden Erfindung kann der Whiskerbereich einen mittleren Radius von zumindest 3 nm und höchstens 30 nm, bevorzugt von zumindest 5 nm und höchstens 25 nm und mehr bevorzugt von zumindest 5 nm und höchstens 20 nm aufweisen.

In einigen Ausführungsformen der vorliegenden Erfindung kann der Sockelbereich eine Höhe von zumindest 20 nm und höchstens 1000 nm, bevorzugt von zumindest 50 nm und höchstens 700 nm und mehr bevorzugt von zumindest 100 nm und höchstens 500 nm aufweisen.

In einigen Ausführungsformen der vorliegenden Erfindung kann dasjenige Ende des Sockelbereichs, das auf dem Substrat angeordnet ist, einen mittleren Radius von zumindest 25 nm und höchstens 1500 nm, bevorzugt von zumindest 40 nm und höchstens 1000 nm und mehr bevorzugt von zumindest 50 nm und höchstens 1500 nm aufweisen.

In einigen Ausführungsformen der vorliegenden Erfindung kann die negative Hauptkrümmung der Oberfläche des Sockelbereichs zumindest $1/(1500 \text{ nm})$ und höchstens $1/(20 \text{ nm})$, bevorzugt zumindest $1/(800 \text{ nm})$ und höchstens $1/(50 \text{ nm})$ und mehr bevorzugt zumindest $1/(500 \text{ nm})$ und höchstens $1/(100 \text{ nm})$ betragen, dabei bevorzugt jedoch höchstens den Kehrwert der Höhe des Sockelbereichs.

Ferner kann die Wechselwirkungsposition des Teilchenstrahls derart gesteuert werden, dass der Sockelbereich und / oder der Mittelbereich der Sondenspitze Schicht für Schicht erzeugt werden, wobei der Teilchenstrahl je Schicht entlang von im Wesentlichen ellipsenförmigen, bevorzugt kreisförmigen, Flächen gesteuert wird.

Insbesondere kann dabei zumindest eine Halbachse der ellipsenförmigen Flächen eine Funktion der Höhendifferenz zwischen der zugehörigen Schicht und der Oberfläche des Substrats sein, wobei die Funktion einen Abschnitt einer Ellipse, insbesondere eines Kreises, beschreibt.

Beispielsweise kann der Radius r der kreisförmigen Flächen mit der Höhe h der zugehörigen kreisförmigen Schicht über die folgende Gleichung verknüpft sein:

$$ r(h) = r_H + r_k - \sqrt{r_k^2 - (H-h)^2}, (\text{Gl. 2}) $$

wobei H die Gesamthöhe des Sockelbereichs, $r_k$ der Absolutwert des negativen Haupkrümmungsradius der Oberfläche und $r_H$ der Radius der obersten Schicht des Sockelbereichs ist, wobei im Allgemeinen gilt: $h \in [0, H]$ und $r_k \geq H$. Die obige Gleichung lässt sich für h=o nach dem Hauptkrümmungsradius $r_k$ auflösen. Man erhält:

$$ r_k = \frac{(r_0 - r_H)}{2} + \frac{H^2}{2(r_0 - r_H)}, (\text{Gl. 3}) $$

wobei $r_0$=r(0), d.h. $r_0$ ist der Radius der untersten Schicht. Für $r_H$=0 und $r_0$=H erhält man folglich $r_k$=H.

Als weiteres Beispiel erhält man mit H = 500 nm, $r_k$ = 750 nm und $r_H \in$ 10 nm einen negativ gekrümmten Sockelbereich mit einem unteren Durchmesser von ca. 400 nm einer Gesamthöhe von 500 nm und einem oberen Durchmesser von 20 nm. Dabei beträgt der Durchmesser des Sockelbereichs bei einer Höhe von 300 nm nur noch ca. 74nm.

Durch weiteres Abscheiden von Material auf der obersten Schicht des Sockelbereichs kann nun ein Whiskerbereich auf dem Sockelbereich erzeugt werden. Beispielsweise beträgt dabei der Durchmesser des Whiskerbereichs 2 x $r_H$. Im obigen Beispiel hat der Whiskerbereich dann einen Durchmesser von 20 nm. Die Länge des Whiskerbereichs kann dabei nahezu beliebig eingestellt werden. Beispielsweise können Whiskerbereiche mit einer Länge von 400 nm oder gar 1000 nm erzeugt werden.

Dadurch kann eine Sondenspitze erzeugt werden, bei der ein negativ gekrümmter Sockelbereich kontinuierlich in einen Whiskerbereich übergeht ohne, dass die Krümmung der Sondenspitze jemals positiv wird. Formbedingte Schwachstellen der Sondenspitze (siehe Fig. 2 unten) können dadurch komplett vermieden werden. Andere funktionelle Zusammenhänge zwischen Halbachse r und Höhe h der Schicht sind selbstverständlich auch denkbar, um eine negativ gekrümmte Oberfläche des Sockelbereichs zu erhalten.

In einigen Ausführungsformen der vorliegenden Erfindung können die Abrasterparameter des Teilchenstrahls dabei so gewählt werden, dass beim einmaligem Abrastern mit dem Teilchenstrahl nur ein Bruchteil einer Schicht - mit einer Dicke, die im Wesentlichen dem Abstand des atomaren Kristallgitters entspricht - deponiert wird. So kann eine im Wesentlichen kontinuierlicher Sondenspitze ohne einen diskreten Schichtaufbau erzeugt werden, wie es beispielsweise bei Verfahren wie Atomlagenepitaxie oder Atomlagenabscheidung der Fall sein kann.

Ferner kann in einigen Ausführungsformen das teilchenstrahlinduzierte Erzeugen und / oder Bearbeiten der Sondenspitze während des Herstellens der Sonde für eine bestimmbare Zeitdauer, bevorzugt für höchstens 1000 ms, mehr bevorzugt für höchstens 500 ms und am meisten bevorzugt für höchstens 50 ms zumindest einmal unterbrochen werden.

Beispielsweise kann der Teilchenstrahl, nachdem eine Schicht der Sondenspitze erzeugt worden ist, für eine vorbestimmte Dauer in eine Ruheposition bewegt werden.

Dadurch kann beim teilchenstrahlinduzierten Abscheiden des Spitzenmaterials aus der Gasphase beispielsweise erreicht werden, dass die Konzentration des Vorläufergases im relevanten Wechselwirkungsvolumen während des Erzeugens der Sondenspitze im Wesentlichen konstant gehalten wird.

In dieser Weise kann die gewünschte Form der Sondenspitze effizient und einfach erzeugt werden und dabei gleichzeitig eine möglichst homogene Dichte und Materialzusammensetzung der Sondenspitze erreicht werden, was das Auftreten von strukturellen Schwachstellen der Sondenspitze zusätzlich reduziert.

In einigen Ausführungsformen kann das Verfahren ferner den Schritt des Justierens des Teilchenstrahls vor und / oder während des Herstellens der Sonde basierend auf einer teilchenoptischen Messung zumindest eines Teils des Substrats und / oder der zu erzeugenden Sondenspitze umfassen.

Insbesondere kann das Justieren des Teilchenstrahls zumindest teilweise auf zumindest einer auf dem Substrat angebrachten, insbesondere darauf abgeschiedenen, Markierung basieren.

Beispielsweise kann das Justieren des Teilchenstrahls zumindest einen der folgenden Schritte umfasst:

    a. Anpassen einer Fokusposition des Teilchenstrahls;
    b. Korrigieren eines Strahlfehlers des Teilchenstrahls;
    c. Korrigieren eines Astigmatismus des Teilchenstrahls;
    d. Anpassen des Teilchenflusses des Teilchenstrahls; und
    e. Anpassen der mittleren kinetischen Energie der Teilchen des Teilchenstrahls.

In dieser Weise können während des Herstellens der Sonde auftretende Verschiebungen des Substrats und / oder des Teilchenstrahls aktiv korrigiert werden und dadurch die Qualität der erzeugten Sondenspitze sowie die Reproduzierbarkeit des Herstellungsverfahrens verbessert werden.

In einigen Ausführungsformen kann das Verfahren ferner den Schritt des elektrischen Entladens der Sonde, vorzugsweise durch Wechselwirkung mit Ionen aus einem Plasma, umfassen.

Dadurch kann beispielsweise sichergestellt werden, dass die Sonde während des Erzeugens der Sondenspitze elektrisch neutral bleibt und dadurch die Trajektorien der Teilchen des Teilchenstrahls nicht beeinflusst. Zusätzlich führt das Entladen der Sonde auch dazu das die Sonde im anschließenden Betrieb in einem Rastersondenmikroskop elektrisch neutral bleibt, was die Qualität von Rastersondenmikroskop-Messungen erhöhen kann.

Zusätzlich kann wie in US 7,232,997 beschrieben ein gitterförmiges Abschirmelement verwendet werden, um während des Erzeugens oder Bearbeitens der Sondenspitze ein elektrisches Aufladen der Sonde zu reduzieren.

Eine weitere Ausführungsform der vorliegenden Erfindung betrifft ein Verfahren zum Herstellen von Sonden für Rastersondenmikroskope umfassend die folgenden Schritte: Bereitstellen von einem ersten und zumindest einem zweiten Substrat; Erzeugen eines Referenzbildes des ersten Substrats; Erzeugen von zumindest einem Objektbild des zumindest zweiten Substrats; Bestimmen zumindest einer Transformation zwischen dem Referenzbild und dem zumindest einen Objektbild; und teilchenstrahlinduziertes Erzeugen und / oder Bearbeiten zumindest einer Sondenspitze auf dem zumindest zweiten Substrat basierend auf der zumindest einen bestimmten Transformation.

Insbesondere, kann beim Bestimmen der zumindest einen Transformation ein aus dem Bereich der Bildregistrierung bekanntes Verfahren verwendet werden.

Mit Hilfe des oben beschriebenen Verfahrens kann erreicht werden, dass die Sondenspitze auf dem zumindest zweiten Substrat im Wesentlichen an der gleichen Position wie die Sondenspitze des ersten Substrats erzeugt wird. Insbesondere erlaubt es das Verfahren die Herstellung einer Vielzahl von Sondenspitzen auf einer Vielzahl von Substraten zu automatisieren.

Beispielsweise kann es das Verfahren ermöglichen, dass nur die Position der Sondenspitze auf dem ersten Substrat manuell eingestellt werden muss und alle weiteren Positionen aller weiteren zu erzeugenden Sondenspitzen automatisch bestimmt werden.

Das Verfahren kann ferner das Bestimmen einer Höhendifferenz zwischen dem ersten und dem zumindest zweiten Substrat, vorzugsweise durch ein lichtoptisches Messverfahren, umfassen. Beispielsweise kann hierbei ein interferometrisch arbeitender optischer Höhensensor verwendet werden. Zusätzlich oder alternativ kann die Funktionsweise des Höhensensors auch auf dem Bestimmen von chromatischen Aberrationen basieren, wie etwa in der DE 10 2016 115 827 A1 beschrieben.

Das Verfahren kann ferner das automatische Justieren eines Teilchenstrahls basierend auf zumindest einer teilchenoptischen Messung des jeweiligen Substrats umfassen.

Das Verfahren kann ferner das Erzeugen von zumindest einer, vorzugsweise zwei, Markierung auf dem Substrat jeweils neben der zu erzeugenden Sondenspitze umfassen. Insbesondere können jeweils auf einer Seite neben der eigentlichen Sondenspitzen zwei weitere Sondenspitzen oder Whiskerbereiche erzeugt werden, die als Markierungen und / oder Referenzobjekte für die Justage der Teilchenstrahloptik dienen können.

Insbesondere kann das automatische Justieren des Teilchenstrahls ein automatisches Justieren eines Fokus und / oder ein automatisches Korrigieren eines Astigmatismus des Teilchenstrahls umfassen.

Zusätzlich kann das Verfahren auch den Schritt des Erzeugens zumindest einer Testspitze auf dem ersten Substrat und / oder dem zumindest zweiten Substrat umfassen.

Eine solche Testspitze kann beispielsweise dazu verwendet werden um die korrekte Justage des Teilchenstrahls zu überprüfen.

In einer weiteren Ausführungsform stellt die vorliegenden Erfindung ein Verfahren zur Herstellung einer Sonde für ein Rastersondenmikroskop mit den folgenden Schritten bereit: Konstruieren eines Sondenspitzendesigns basierend auf einer Mehrzahl von auswählbaren Untereinheiten; und teilchenstrahlinduziertes Erzeugen und /oder Bearbeiten einer Sondenspitze auf einem Substrat zumindest teilweise basierend auf dem konstruierten Sondenspitzendesign.

Insbesondere kann das Konstruieren des Sondenspitzendesigns das Festlegen von zumindest einem Parameter von zumindest einer der auswählbaren Untereinheiten umfassen, wobei der zumindest eine Parameter zumindest eines der folgenden umfasst:

a. eine geometrische Form der zumindest einen auswählbaren Untereinheit;
b. eine Abmessung der zumindest einen auswählbaren Untereinheit;
c. eine Krümmung einer Oberfläche der zumindest einen auswählbaren Untereinheit;
d. eine Steigung einer Oberfläche der zumindest einen auswählbaren Untereinheit;
e. ein Material der zumindest einen auswählbaren Untereinheit; und
f. eine Dichte der zumindest einen auswählbaren Untereinheit.

Beispielsweise kann die Mehrzahl von auswählbaren Untereinheiten zumindest einen Sockelbereich, zumindest einen Whiskerbereich, zumindest einen Mittelbereich und zumindest eine Kappe des Sondenspitzendesigns umfassen.

Das bereitgestellte Verfahren ermöglicht es beispielsweise, sondergefertigte, anwendungsspezifische Sonden für Rastersondenmikroskope in einfacher und effizienter Weise zu konstruieren und herzustellen.

Insbesondere ermöglicht es das Zusammenstellen eines Sondenspitzendesigns aus einer vorbestimmten Mehrzahl an Untereinheiten (Baukastenprinzip) auch einem Anwender, der sich ggf. mit der Herstellung von solchen Sondenspitzen nur rudimentär auskennt, in wenigen Schritten eine funktionstüchtige und auch herstellbare Sondenspitze zu konstruieren.

Insbesondere kann das Verfahren ferner umfassen: computergestütztes Überprüfen, ob das Sondenspitzendesign durch teilchenstrahlinduziertes Erzeugen und /oder Bearbeiten auf einem Substrat herstellbar ist, wobei das Überprüfen zumindest eine Randbedingung des teilchenstrahlinduzierten Erzeugens oder Bearbeitens und / oder zumindest eine Konsistenzbedingung des Sondenspitzendesigns berücksichtigt.

Beispielsweise kann ein solches Überprüfen auf einem sog. *Design Rule Check* (DRC) basieren, wie es beispielsweise aus der Fertigung von Leiterplatten, CNC-Bauteilen oder der additiven Fertigung bekannt ist.

In dieser Weise kann sichergestellt werden, dass der Anwender nur solche Untereinheiten und Konstruktionsparameter auswählt und miteinander kombiniert, die zueinander konsistent sind und mit denen sich die resultierende Sondenspitze auch fertigen lässt.

Ferner kann das Verfahren umfassen: Steuern einer Wechselwirkungsposition eines Teilchenstrahls basierend auf dem konstruierten Sondenspitzendesign.

Insbesondere kann aus dem konstruierten Sondenspitzendesign eine Steuertrajektorie für die Wechselwirkunsposition des Teilchenstrahls bestimmt werden, die dann während der Herstellung der Sondenspitze Schicht für Schicht abgerastert wird.

An dieser Stelle sei darauf hingewiesen, dass sich die Verfahren der unterschiedlichen oben beschriebenen Ausführungsformen auch miteinander kombinieren lassen. Beispielsweise kann die Mehrzahl von Untereinheiten auch gekrümmte Sockelbereiche umfassen, die derart konstruiert sind, dass sie kontinuierlich in einen Whiskerbereich übergehen können.

Ferner können die Untereinheiten in der Mehrzahl an Untereinheiten jeweils mit zumindest einem der folgenden Parameter assoziiert sein:

a. einem Anwendungsbereich der Sonde;
b. einer für die Sonde spezifischen Messmethode;
c. einer für die Sonde spezifischen Art von Messobjekt;
d. einem für die Sonde spezifischem Typ von Rastersondenmikroskop; und
e. einem Substrattyp.

In einer weiteren Ausführungsform stellt die vorliegende Erfindung eine Sonde für ein Rastersondenmikroskop bereit, wobei die Sonde aufweist: ein Substrat und eine auf dem Substrat angeordnete Sondenspitze, wobei eine seitliche Oberfläche eines Sockelbereich der Sondenspitze eine im Wesentlichen negative Krümmung aufweist; und wobei die Sonde nach einem Verfahren nach einer der vorhergehenden Ausführungsformen des vorliegenden Erfindung hergestellt worden ist.

Wie oben bereits detailliert ausgeführt weisen derartige Sonden eine signifikant niedrigere Abbruchwahrscheinlichkeit auf als konventionelle Sonden mit einem vergleichbaren Auflösungsvermögen.

In einer weiteren Ausführungsform stellt die vorliegende Erfindung eine Vorrichtung zur Herstellung einer oder einer Mehrzahl von Sonden für ein Rastersondenmikroskop bereit, wobei die Vorrichtung aufweist: Mittel zum Durchführen eines Verfahrens nach einer der vorgehend beschriebenen Ausführungsformen; und Mittel zum Ausführen eines Computerprogramms.

In einer weiteren Ausführungsform stellt die vorliegende Erfindung ein Computerprogramm bereit mit Anweisungen zum Durchführung eines Verfahrens nach einer der vorgehend beschriebenen Ausführungsformen mit einer wie vorgehend beschriebenen Vorrichtung.

Eine solche Vorrichtung und / oder ein solches Computerprogramm ermöglichen es insbesondere sondergefertigte, anwendungsspezifische Sonden mit robusten und verschleißarmen Sondenspitzen in einem automatisierten Verfahren in großer Stückzahl und mit gleichbleibender Qualität herzustellen.

## 4. Beschreibung der Zeichnungen

Gewisse Aspekte der vorliegenden Erfindung werden im Folgenden mit Bezugnahme auf die angefügten Zeichnungen beschrieben. Diese Zeichnungen zeigen:

Fig. 1     ein schematischer Querschnitt durch eine aus dem Stand der Technik bekannte Sonde

Fig. 2     eine teilchenoptische Aufnahme einer aus dem Stand der Technik bekannten Sondenspitze

Fig. 3     eine schematische Darstellung einer Sondenspitze für Rastersondenmikroskope, die mit einem Verfahren nach einer Ausführungsform der vorliegenden Erfindung erzeugt werden kann

Fig. 4     eine schematische Darstellung einer beispielhaften Trajektorie einer Wechselwirkungsposition eines Teilchenstrahls beim Erzeugen einer Sondenspitze für Rastersondenmikroskope gemäß einem Verfahren nach einer Ausführungsform der vorliegenden Erfindung

Fig. 5     eine schematische Darstellung eines Probenhalters einer Teilchenstrahlvorrichtung zur Herstellung von Sonden für Rastersondenmikroskope gemäß einer Ausführungsform der vorliegenden Erfindung

Fig. 6     Block-Ablaufdiagram eines automatisierten Verfahrens zur Herstellung einer Vielzahl von Sonden für Rastersondenmikroskope nach einer Ausführungsform der vorliegenden Erfindung

Fig. 7     eine schematische Seitenansicht und Draufsicht einer Sonde für Rasterkraftmikroskope, die mit einem Verfahren nach einer Ausführungsform der vorliegenden Erfindung erzeugt werden kann

Fig. 8     ein Diagramm zur Darstellung von Transformationen zwischen verschiedenen Koordinatensystemen, die bei der Herstellung von Sonden für Rastersondenmikroskope gemäß einem Verfahren nach einer Ausführungsform der vorliegenden Erfindung verwendet werden

Fig. 9     drei schematische Draufsichten auf einen Teil einer Sonde während des Justierens eines Teilchenstrahls gemäß einem Verfahren nach einer Ausführungsform der vorliegenden Erfindung

Fig. 10     eine schematische Darstellung eines Konstruktionsverfahrens für anwendungsspezifische Sonden für Rastersondenmikroskope nach einer Ausführungsform der vorliegenden Erfindung

Fig. 11     schematische Darstellung eines Sondenspitzendesigns mit modifizierbaren Abmessungen gemäß einem Verfahren nach einer Ausführungsform der vorliegenden Erfindung.

## 5. Detaillierte Beschreibung einiger Ausführungsbeispiele

Im Folgenden werden einige beispielhafte Ausführungsbeispiele der vorliegenden Erfindung im mit Bezugnahme auf die angefügten Zeichnungen beschrieben. Die beanspruchten Verfahren, Vorrichtung und Computerprogramm zur Herstellung von Sonden für Rastersondenmikroskope sind jedoch nicht auf solche Ausführungsformen beschränkt. Vielmehr ist zu verstehen, dass auch andere Merkmalskombinationen unter den Schutzbereich der Erfindung fallen können. Mit anderen Worten müssen nicht alle Merkmale der beschriebenen Ausführungsformen vorhanden sein, um die vorliegenden Erfindung zu realisieren. Des Weiteren könne die Ausführungsformen durch Kombinieren gewisser Merkmale einer Ausführungsform mit einem oder mehreren Merkmalen einer anderen Ausführungsform modifiziert werden, ohne von der Offenbarung und dem Schutzumfang der vorliegenden Erfindung abzuweichen.

Fig. 1 zeigt schematisch den Aufbau einer konventionellen Sonde für Rastersondenmikroskope. Auf eine Substrat 110 wie z.B. einem Federbalken ist eine Sondenspitze 120 angeordnet. Diese kann z.B. über Teilchenstrahlabscheidung erzeugt werden. Die dargestellte Sondenspitze 120 umfasst dabei einen konusförmigen Sockel 130 der auf dem Substrat 110 abgeschieden ist. Auf dem Sockel 130 ist ein sogenannter Whisker 140 abgeschieden, der die eigentliche Messspitze darstellt. Üblicherweise ist dabei der Durchmesser des Whiskers 140 wesentlich geringer als der Durchmesser des Sockels 130. Die gestrichelten Pfeile zeigen die potentiellen strukturellen Schwachstellen WP der dargestellten Sondenspitze. Insbesondere der Übergang zwischen Sockel 130 und Whisker 140 ist anfällig für ein Abrechen des Whiskers 140.

Fig. 2 zeigt eine elektronenoptische Aufnahme einer beispielhaften Sondenspitze wie sie aus dem Stand der Technik bekannt ist. Bei der gezeigten Sondenspitze geht ein konusförmiger Sockel 230 über eine kurze konusförmige Übergangszone in eine konusförmige Spitze 240 über. Die gezeigte Form der Sondenspitze weist im Allgemeinen eine im Vergleich zu der in Fig. 1 dargestellten Form verbesserte Stabilität auf. Dennoch bildet die Übergangsregion zwischen Sockel und Spitze eine klar definierte Schwachstelle WP (gezeigt durch den gestrichelten Pfeil) der Sondenspitze, an der es regelmäßig zum Abbruch der Spitze 240 kommt.

Fig. 3 zeigt schematisch eine Sonde 300 für Rastersondenmikroskope, die mit einem Verfahren nach einer Ausführungsform der vorliegenden Erfindung hergestellt werden kann. Auf einem Substrat 310 wie z.B. einem Federbalken ist eine Sondenspitze 320 angeordnet. Die Sondenspitze 320 kann beispielsweise durch teilchenstrahlinduziertes Abscheiden von Material aus der Gasphase erzeugt werden.

Die Sondenspitze 320 umfasst einen integrierten Sockelbereich 330 und einen Whiskerbereich 340. Der Sockelbereich 330 ist dabei so geformt, dass dessen seitliche Oberfläche eine ausgeprägte negative Krümmung aufweist. Dadurch kann erreicht werden, dass der Durchmesser des Sockelbereichs 330 am unteren Ende wesentlich größer ist als der Durchmesser des Whiskerbereichs 340, wodurch ein Ablösen des Sondenspitze 320 vom Substrat 310 unterbunden werden kann. Die negativ gekrümmte Oberfläche des Sockelbereichs 330 führt ebenfalls dazu, dass der Durchmesser des Sockelbereichs 330 schnell genug abnimmt, um ein großes Aspektverhältnis der Sondenspitze 320 zu gewährleisten. Insbesondere geht der Sockelbereich 330 kontinuierlich in den Whiskerbereich 340 über, ohne dass es zu lokalisierten und / oder ausgeprägten Schwachstellen kommt, wie es bei den aus dem Stand der Technik bekannten Sondenspitzen der Fall ist.

Fig. 4 zeigt schematisch eine mögliche Trajektorie der Wechselwirkungsposition 410 eines Teilchenstahls mit dem die Sondenspitze 320 aus Fig. 2 erzeugt werden kann. In der gezeigten Ausführungsform der vorliegenden Erfindung wird die Sondenspitze Schicht für Schicht aufgebaut bzw. auf den Substrat 310 abgeschieden. Die Wechselwirkungsposition 410 des Teilchenstrahls wird dabei je Schicht entlang konzentrischen Kreisen 420 kontrolliert geführt. Beispielsweise kann die Wechselwirkungsposition 410 des Teilchenstrahls durch Verschieben des Probenhalters der Teilchenstrahlvorrichtung, die zum Erzeugen der Sondenspitze verwendet wird, und / oder durch Steuern des Teilchenstrahls kontrolliert werden. Insbesondere kann dadurch erreicht werden, dass die Sondenspitze in einem Stück erzeugt wird, um eine glatte, kontinuierliche Sondenspitze ohne Schwachstellen zu erhalten.

In diesem Zusammenhang ist zu erwähnen, dass der Verschleiß von Sondenspitzen direkt von ihrer Materialzusammensetzung abhängt. Für Anwendungen wie die Reparatur von Photolithographiemasken sind beispielsweise sogenannte DLC-Spitze (DLC: diamond like carbon) vorzuziehen, da es sich um ein sehr hartes Material handelt. Um eine solche DLC-Spitze abzuscheiden, ist es zwingend erforderlich, eine saubere Depositionskammer zu verwenden. Dies kann durch regelmäßige Reinigung der Depositionskammer der Teilchenstrahlvorrichtung vor dem Laden der Substrate erreicht werden. Beispielsweise kann die Depositionskammer durch ein Plasmareinigungsverfahren und /oder auch durch Ätzgasreinigung behandelt werden.

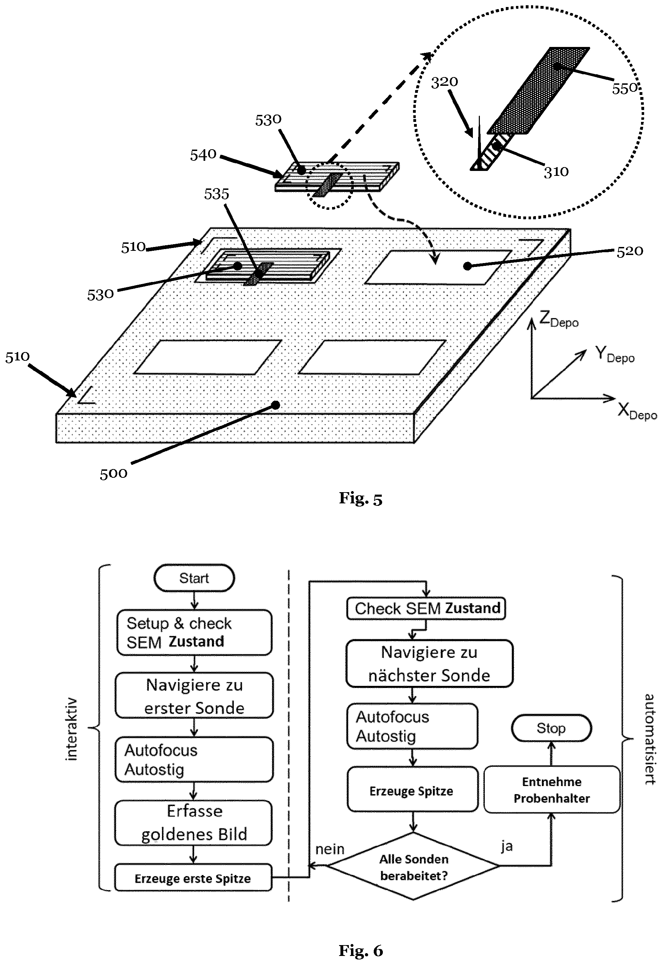

Fig. 5 zeigt schematisch die Konstruktion eines Probenhalters 500, der für die automatisierte Herstellung einer Vielzahl von Sonden für Rastersondenmikroskope geeignet ist und in einem Verfahren nach einer Ausführungsform der vorliegenden Erfindung zum Einsatz kommen kann. Der Probenhalter 500 weist eine Vielzahl von Aufnahmepositionen 520 für eine Vielzahl von Sondenhaltern 530 auf. Zusätzlich sind auf dem Probenhalter 500 Fiduzialmarkierungen 510 angeordnet, die zur Positionsbestimmung verwendet werden können. Auf jedem Sondenhalter 530 ist eine Sonde 535 befestigt. Die Sonde 535 weist dabei eine Grundfläche 550 und einen Federbalken 310 auf der als Substrat für die Erzeugung der jeweiligen Sondenspitze 320 dient. Auf jedem Sondenhalter 530 sind wiederum Fiduzialmarkierungen 540 angeordnet, die zusammen mit den Fiduzialmarkierungen 510 des Probenhalters 500 zu Positionsbestimmung verwendet werden können. Alternativ können auf jedem Sondenhalter auch jeweils eine Mehrzahl von Sonden wie z.B. ein Sonden-Array angeordnet sein.

Fig. 6 zeigt ein Blockdiagramm eines teilautomatisierten Herstellungsverfahrens für eine Vielzahl von Sonden für Rastersondenmikroskope, bei dem ein Probenhalter wie in Fig. 5 gezeigt verwendet werden kann. Das Verfahren von Fig. 6 lässt sich in eine interaktive Phase (interaktiv, Engl. Interactive) und eine automatisierte Phase (automatisiert, Engl. Automated) unterteilen.

Hierbei werden alle nicht automatisierbaren Verarbeitungsschritte zusammengefasst, so dass während der automatisierten Verarbeitungsphase keine Bedienertätigkeit erforderlich ist. Dies ermöglicht eine automatisierte Chargenfertigung, was die Kosten für die Spitzenfertigung und die Herstellungsdauer deutlich reduziert.

Der Prozess beginnt damit, dass alle Systeme der Herstellvorrichtung (z.B. eines Elektronenmikroskops) in einen optimierten Zustand versetz werden und alle Verarbeitungsparameter richtig eingestellt werden (Setup & check SEM Zustand). Dazu können vordefinierte Prozessrezepte und vordefinierte Referenzwerte für Messparameter (z.B. der Teilchenstrahls) überprüft bzw. eingestellt werden. Optional können alle Parameter protokolliert werden, um verschiedene Qualitätssicherungsmaßnahmen zu unterstützen.

Das Setup der Herstellungsvorrichtung beinhaltet auch das teilchenoptische Abbilden der Fiduzialmarkierungen 510, 540 (siehe Fig. 5 oben), die zum Bestimmen der benötigten Koordinatentransformationen verwendet werden (siehe Verfahrensschritt "Navigation" unten). Nach der manuellen oder automatischen Navigation zur ersten Sonde werden die Verfahrensschritte Autofokus und Autostig (kurz für automatisierte Astigmatismuskorrektur) durchgeführt (siehe unten).

Dann wird ein Referenzbild (sog. *goldenes Bild; engl. golden image*) des ersten Sondenhalters 530 mit dem darauf befestigten ersten Sondenrohling 535 erzeugt (Erfasse goldenes Bild; Engl. Acquire golden image).

Das Aufnehmen des Referenzbildes dient dabei zwei Zwecken: Zuerst wird die Bildqualität vom Bediener überprüft, um sicherzustellen, dass Fokus und Stigmator korrekt eingestellt sind.

Zweitens wird das Referenzbild für die später verwendete Bildregistrierung (siehe Verfahrensschritt *"Navigation"* unten) verwendet, was es erlaubt die weiteren Sondenrohlinge 535 automatisch anzufahren und die Vielzahl von Sondenspitzen 320 automatisch zu erzeugen. Die interaktive Phase endet mit dem Erzeugen der ersten Sondenspitze 320 auf dem Federbalken 310 des ersten Sondenrohling 535 (Erzeuge erste Spitze; Engl. Deposit 1st tip).

Für die restlichen Sonden durchläuft das System automatisch die rechts neben der gestrichelten Linie in Fig. 6 dargestellten Prozessschritte, bevor der Probenhalter aus der Prozesskammer der Herstellungsvorrichtung entfernt werden kann (Entnehme Probenhalter; Engl. Unload Deposition holder). Die einzelnen Schritte der Prozesskette der automatisierten Phase werden im Folgenden beschrieben:

Überprüfen des Zustands der Teilchenstrahlvorrichtung (Check SEM Zustand):

In diesem Schritt wird eine automatische Prüfung der Herstellungsvorrichtung durchgeführt. Die automatisierte Prüfung vergleicht einen Satz von Parameterwerten mit den während der interaktiven Phase gemessenen Werten. Beispiele sind der Teilchenextraktionsstrom, der Teilchenstrahlstrom und Vakuumdruck in der Prozesskammer. Überprüft wird hierbei auch die Gaszufuhr des Vorläufergases (z.B. der Vorläufergasdruck oder die Reservoirtemperatur). Zusätzlich kann vor dem Abscheiden jeder weiteren Sondenspitze ein Kontaminationstest durchgeführt werden.

Automatisches Anfahren der Sondenrohlinge (Navigation)

In diesem Schritt des Verfahrens wird der jeweilige Sondenrohling 535 auf dem die Sondenspitze 320 automatisiert erzeugt werden soll automatisch angefahren. Das heißt beispielsweise, dass der Probentisch des für die Erzeugung verwendeten Elektronenmikroskops so verfahren wird, dass der nächste Sondenrohling im Abbildungsbereich des Elektronenmikroskops zentriert wird.

Das automatisierte Anfahren des jeweiligen Sondenrohlings 535 basiert in der vorliegenden Ausführungsform auf einem dreistufigen Verfahren. Dieses Verfahren dient vor allem dazu die Positionsunsicherheit jedes neu angefahrenen Sondenrohlings 535 aufgrund von Platzierungsfehlern des Sondenhalters 530 relativ zum Probenhalter 500 zu beseitigen. Zusätzlich entsteht ein weiterer Positionsfehler der Sondenrohlinge 535, dadurch, dass die Sondenrohlinge 535 nicht immer identisch auf dem zugehörigen Sondenhalter 530 angeordnet sind.

Mit anderen Worten dient das beschriebenen Navigationsverfahren dazu, die Relativposition der Sondenrohlinge 535 in Bezug auf die aus der interaktiven Phase bekannte Position der Fiduzialmarkierungen 510 des Probenhalters 500 zu bestimmen.

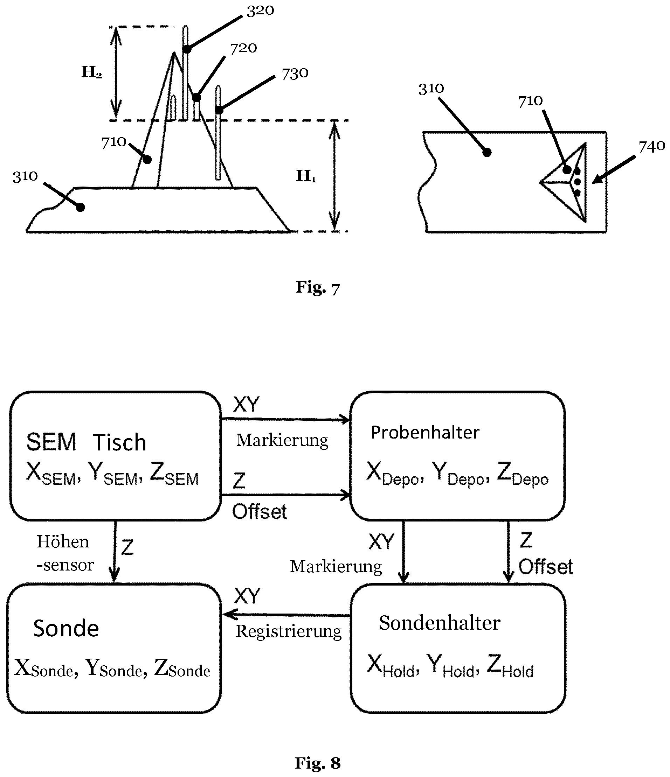

Dazu werden wie in Fig. 8 dargestellt vier Koordinatensysteme (SEM Tisch, Probenhalter, Sondenhalter, Sonde; Engl. SEM Stage, Deposition Holder, Probe Holder, Probe) definiert, die jeweils dem Probentisch der Teilchenstrahlvorrichtung, dem Probenhalter 500, dem jeweiligen Sondenhalter 530 und dem jeweiligen Sondenrohling 535 zugeordnet sind.

Um die Koordinaten der verschiedenen Koordinatensysteme zu transformieren, muss eine Vielzahl von Parametern ermittelt werden. Da teilchenoptische Bilder zweidimensional sind, können diese nur für die Zuordnung von X- und Y-Koordinaten verwendet werden.

Durch teilchenoptische Aufnahmen der Fiduzialmarkierungen 510 des Probenhalters 500 und der Sondenhalter 535 und das Bestimmen der Koordinaten des Probentisches für jedes der aufgenommen Bilder können die Parameter für die XY-Abbildung zwischen den bekannten und steuerbaren Koordinaten des Probentisches, des Probenhalters 500 und jedem der Sondenhalter 530 gefunden werden.

Mit anderen Worten kann die Position jedes der Sondenhalter 530 (genauer der Fiduzialmarkierungen 540) durch verschieben des Probentisches in der XY-Ebene präzise kontrolliert werden, ohne dass der Bediener eingreifen muss.

Um die noch fehlende Koordinatentransformation zwischen dem Sondenhalter 530 und dem zugehörigen Sondenrohling 535 zu bestimmen kann beispielsweise die sogenannte *Bildregistrierung* verwendet werden. Hierbei wird von jedem Sondenhalter 530 und dem darauf befestigten Sondenrohling 535 ein teilchenoptisches Bild, das sogenannte *Objektbild* aufgenommen.

Durch aus der Bildregistrierung bekannte Verfahren wie z.B. einem Korrelationsverfahren oder einem auf räumlicher Fourier-Analyse basierten Verfahren kann eine optimale Transformation zwischen dem jeweiligen Objektbild und dem während der interaktiven Phase aufgenommenen Referenzbild des ersten Sondenhalters 530 und des ersten Sondenrohlings 535 bestimmt werden.

Durch Kombination mit der bereits bekannten XY-Abbildung zwischen den Koordinaten des Probentisches und jedem der Sondenhalter 530 kann eine XY-Abbildung zwischen der bekannten und kontrollierbaren Position des Probentisches und der Position des jeweiligen Sondenrohlings 535 bestimmt werden.

Die resultierende XY-Abbildung kann nun beispielsweise verwendet werden, um die Mitte jedes des Federbalken 310 jedes der Probenrohlinge 535 automatisch (in der XY-Ebene) mit dem verschiebbaren Probentisch der Teilchenstrahlvorrichtung anzufahren, um dort automatisiert eine Probenspitze 320 zu erzeugen. Alternativ oder zusätzlich könne auch die Sondenrohlinge 535 mit eigenen Fiduzialmarkierungen versehen werden, um die Genauigkeit der Navigation zu verbessern.

Das Bestimmen der Koordinatentransformation in Z-Richtung basiert einerseits auf sehr genau bekannte Höhenunterschieden zwischen Probentisch, Probenhalter 500, den Sondenhaltern 530 und den Sondenrohlingen 535. Dies kann insbesondere durch sehr präzise Fertigungstoleranzen der jeweiligen Bauteile erreicht werden.

Die noch verbleibende Unsicherheit im Höhenunterschied zwischen der Oberfläche des Probenhalters 500 und der Oberfläche des jeweiligen Federbalkens 310 kann mit Hilfe eines optischen Höhensensors bestimmt werden. Hier kann beispielsweise eine interferometrische und /oder auf chromatischen Aberrationen basierende Längenmessung zum Einsatz kommen.

Autofokus und automatisierte Astigmatismuskorrektur (Autofocus, Autostig)

Um den bestmöglichen Fokus des Teilchenstrahls, der für das automatisierte Erzeugen der Sondenspitzen 320 verwendet wird, zu erhalten, muss der Fokus nach jedem Anfahren des nächsten Sondenrohlings 535 neu eingestellt werden. Optional kann dabei auch der Stigmator und /oder andere Strahloptiken der Teilchenstrahlvorrichtung neu justiert werden.

Aus dem Stand der Technik sind zahlreiche Methoden zur Automatisierung der Fokussierung und Astigmatismuskorrektur (Auto-Stig) von Teilchenmikroskopen und Teilchenstrahlvorrichtungen bekannt, die jedoch die spezifischen Anforderungen an das teilchenstrahlinduzierte Erzeugen und / oder Bearbeiten von Sondenspitzen für Rastersondenmikroskope nicht vollständig berücksichtigen.

Falls eine Sondenspitze 320 auf eine bereits vorhandene Standardspitze 710 eines Federbalkens 310 aufgebracht werden soll (siehe Fig. 7), sind die meisten Bereiche eines teilchenoptischen Bildes der Sondenspitze 320 unscharf und bekannte Autofokus-Methoden und / oder Autostig-Methoden versagen.

Aus diesem Grund wird in einer Ausführungsform der vorliegenden Erfindung das folgende Vorgehen vorgeschlagen:

Zuerst werden Markierungen 720 auf beiden Seiten der Zielposition für die zu fertigende Sondenspitze 320 erzeugt. Dann wird mit dem Erzeugen der Sondenspitze 320 begonnen. Die Markierungen 720 können dann exakt von oben abgebildet werden (da sich der Probentisch der Teilchenstrahlvorrichtung noch in der gleichen Position und Ausrichtung wie beim Erzeugen der Sondenspitze befindet). Mit etablierten Bildverarbeitungsverfahren (Konturerfassung, Kreiserkennung durch Hough-Transformation, etc.) kann dann der Durchmesser des Schafts der spitzenähnlichen Markierungen 720 und Abweichungen von der vorgesehenen Kreisform bestimmt werden.

Beispiele für Algorithmen zur Berechnung von Konturen aus einem teilchenoptischen Bild sind Schwellenwertbildung (z.B. Otsu's Verfahren), Canny-Kantenerkennung, Segmentierung und Wasserscheidenalgorithmen.

Die Analyse der Größe und Form der Kontur des teilchenoptischen Bildes der Markierungen 720 kann verwendet werden, um Fokussier- und Astigmatismusinformationen zu erhalten.

Nachdem die Kontur jeder Markierung 720 berechnet ist, kann eine Ellipse an die Kontur gefittet. Das Verhältnis der Länge der Ellipsenhalbachsen ist ein Maß für die Abweichung von der idealen Kreisform und damit für den vorliegenden Astigmatismus des Teilchenstahls.

Zusätzlich können Kreise an die Konturen der Markierungen 720 gefittet werden, um zu überprüfen, ob die Teilchenstrahlvorrichtung während der Deposition im Fokus war.

Auch ist es möglich an einer weiteren Position eine Testspitze 730 zu erzeugen um die Justage der Teilchenstrahloptik zu überprüfen.

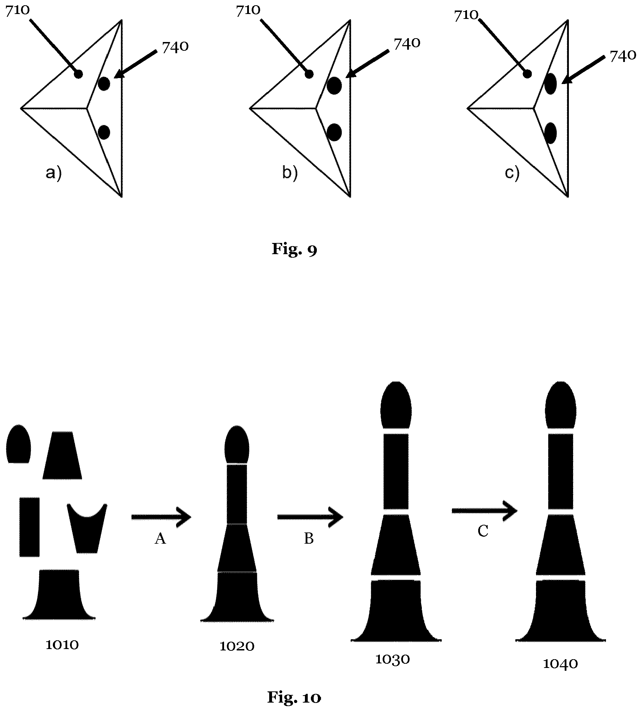

Fig. 9 zeigt schematisch wie aus den Konturen der Markierungen 740 auf eine Defokussierung und / oder einen Astigmatismus des Teilchenstrahls geschlossen werden kann. Ist beispielsweise der Teilchenstrahl im Fokus und der Astigmatismus korrigiert, erhält man kreisförmige Konturen der Markierungen 740 (a). Im Falle einer Defokussierung wird der Radius der Konturen der Markierungen 740 größer als im Fokus (b). Bei einem vorliegenden Astigmatismus Konturen der Markierungen 740 nicht mehr kreisförmig, sondern elliptisch.

Diese Information kann verwendet werden um iterativ und automatisch den Teilchenstrahl zu Fokussieren und einen ggf. vorhanden Astigmatismus zu korrigieren. Die optimierten Einstellungen für den Stigmator und den Fokus sind erreicht, wenn das Verhältnis der Halbachsen der gefitteten Ellipsen so nah wie möglich an 1 liegt und der Kreisradius so klein wie möglich ist. Automatisierte Verfahren zur Optimierung von Teilchenstrahloptiken sind aus dem Stand der Technik bekannt und können auf die vorliegende Optimierungsaufgabe angepasst werden. Durch das Verwenden von zwei Markierungen 740 kann zum Beispiel die Vergrößerung des teilchenoptischen Systems und / oder die Skalierung der damit aufgenommenen teilchenoptischen Bilder überprüft werden.

Das beschriebenen Verfahren befasst sich dabei nicht nur mit der Frage der korrekten Fokussierung und / oder Astigmatismuskorrektur bei spitz zulaufenden Sondenspitzen, sondern hat auch den Vorteil, dass es sich direkt auf häufig spezifizierte Sondenspitzenparameter (wie z.B. den Spitzendurchmesser) bezieht. Dies kann beispielsweise bei Sondenspitzen vorteilhaft sein, die eine speziell gewünschte Form haben sollen. Im Allgemeinen erlaubt es eine korrekte Fokussierung und /oder Astigmatismuskorrektur die Genauigkeit des Herstellungsprozesses solcher Sondenspitzen zu verbessern.

Das vorstehend beschriebene Verfahren ist auch auf Federbalken ohne StandardSpitzen anwendbar.

Erzeugen der Sondenspitze (Tip deposition)

Das Erzeugen der Sondenspitze 320 auf dem jeweils zugehörigen Federbalken 310 funktioniert im Wesentlichen wie zuvor für die anderen Ausführungsformen der vorliegenden Erfindung beschrieben wurde.

Insbesondere ist das Erzeugen der Sondenspitze bereits automatisiert möglich (siehe Fig. 4) und daher unterscheidet sich dieser Schritt der automatisierten Phase nicht von dem Erzeugen der ersten Sondenspitze während der interaktiven Phase.

Nach dem Erzeugen jeder Sondenspitze kann optional ein weiteres teilchenoptisches Bild aufgenommen werden, um das Ergebnis aufzuzeichnen. Optional kann dabei der Probenhalter 500 verkippt werden, so dass auch die Länge der Sondenspitze gemessen werden kann.

Fig. 10 zeigt ein Konstruktionsverfahren für anwendungsspezifische Sondenspitzen für Rastersondenmikroskope nach einer weiteren Ausführungsform der vorliegenden Erfindung. In einem ersten Schritt 1010 kann ein Anwender aus einer Mehrzahl von Untereinheiten auswählen, um ein für die gewünschte Anwendung der Sondenspitze geeignetes Sondenspitzendesign zu konstruieren. Beispielsweise kann der Anwender aus verschieden geformten Sockelbereichen, Mittelbereichen, Whiskerbereichen und Kappen des Sondenspitzendesigns auswählen. Nachdem die Auswahl abgeschlossen ist, wird in einem nächsten Schritt 1020 dem Anwender das komplette Sondenspitzendesign angezeigt. Dieser Schritt kann auch parallel zur Auswahl der Untereinheiten durchgeführt werden.

In einem nächsten Schritt 1030 kann der Anwender verschiedene Konstruktionsparameter der Sondenspitze, wie etwa die Form, die Abmessungen und /oder den Materialtyp, etc. modifizieren. Dieser Schritt kann ebenfalls parallel zu den vorigen Schritten ausgeführt werden.

In einem nächsten Schritt 1030 des Verfahrens wird dem Anwender das modifizierte und / oder vollständig spezifizierte Sondenspitzendesign erneut angezeigt. Dieser Schritt kann ebenfalls parallel zu den vorigen Schritten ausgeführt werden.

In einem weiteren Schritt 1040 kann das modifizierte Sondenspitzendesign automatisch auf Konsistenz und / oder auf seine Herstellbarkeit überprüft werden. Dies kann insbesondere automatisch durch ein Computerprogramm erfolgen und auf einem Satz von vordefinierten Regeln basieren. Beispielswiese kann ein sogenannten *Design Rule Check* (DRC) durchgeführt werden um das modifizierte Sondenspitzendesign auf Konsistenz und /oder Herstellbarkeit zu überprüfen. Dieser Schritt kann ebenfalls parallel zu den vorigen Schritten ausgeführt werden.

Nachdem die Überprüfung des Sondenspitzendesigns abgeschlossen ist, kann eine Datei mit Fertigungsanweisungen, wie z.B. einer Trajektorie für die Wechselwirkungsposition des Teilchenstrahls, einer Spezifikation für die Rasterschrittweite, etc. erstellt werden und an die für die Fertigung der Sondenspitze verwendeten Herstellungsvorrichtung übermittelt werden.

Im Wesentlichen funktioniert der Konstruktions- und Fertigungsprozess der Sondenspitze ähnlich den aus der additiven Fertigung von mechanischen Bauteilen bekannten Prozessschritten. Insbesondere kann der Anwender das Sondenspitzendesign an einem anderen Ort, beispielsweise über eine Web-basierte Anwendung erstellen und in Form einer standardisierten Fertigungsdatei an eine beliebige Fertigungseinrichtung versenden.

Durch die in den Konstruktionsprozess integrierte Überprüfung des Sondenspitzendesigns wird sichergestellt, dass die Sondenspitze auch herstellbar ist. Nachdem eine gewünschte Anzahl an Sonden fertiggestellt worden ist, können diese bei der Fertigungseinrichtung verpackt und an den jeweiligen Anwender verschickt werden. Dadurch wird die Massenfertigung anwendungsspezifischer Sonden für Rastersondenmikroskope ermöglicht.

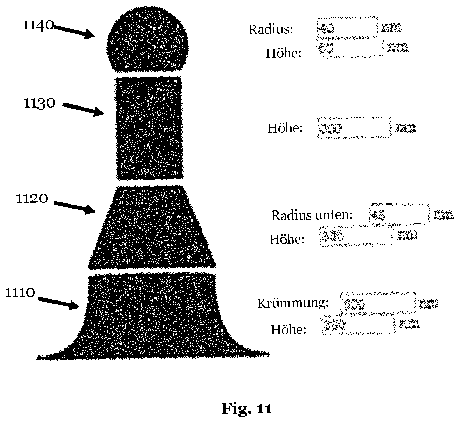

Fig. 11 zeigt ein Beispiel eines modifizierbaren Sondenspitzendesigns bestehend aus einem gekrümmten Sockelbereich 1110 (wie oben diskutiert), einem konusförmigen Mittelbereich 1120, einem zylinderförmigen Whiskerbereich 1130 und eine kugelförmigen Kappe 1140. Durch eine Vielzahl von Eingabefeldern kann der Anwender die relevanten Abmessungen der einzelnen Unterbereiche modifizieren. Durch die oben diskutierte Überprüfung des Sondenspitzendesigns kann sichergestellt werden, dass der Anwender nur solche Untereinheiten und Abmessungen auswählen bzw. eingeben kann, die miteinander kombinierbar, durch eine gegebene Fertigungsvorrichtung herstellbar und in sich konsistent sind.

Weitere Ausführungsformen:

1. Verfahren zur Herstellung einer Sonde (300) für ein Rastersondenmikroskop mit folgenden Schritten:

a. teilchenstrahlinduziertes Erzeugen und / oder Bearbeiten einer Sondenspitze (320) auf einem Substrat (310);

b. wobei eine sich zeitlich verändernde Wechselwirkungsposition (410) eines Teilchenstrahls derart kontrolliert wird, dass eine seitliche Oberfläche eines Sockelbereichs (330) der erzeugten und / oder bearbeiteten Sondenspitze (320) eine negative Krümmung aufweist.

2. Verfahren nach Ausführungsform 1, wobei im Wesentlichen die gesamte seitliche Oberfläche des Sockelbereichs (330) die negative Krümmung aufweist.

3. Verfahren nach einer der vorhergehenden Ausführungsformen, wobei das teilchenstrahlinduzierte Erzeugen und / oder Bearbeiten der Sondenspitze (320) ein teilchenstrahlinduziertes Abscheiden zumindest eines Materials und / oder ein teilchenstrahlinduziertes Ätzen mit zumindest einem Ätzgas umfasst.

4. Verfahren nach einer der vorhergehenden Ausführungsformen, ferner umfassend:

teilchenstrahlinduziertes Erzeugen und / oder Bearbeiten eines Whiskerbereichs (340) oberhalb des Sockelbereichs (330) der Sondenspitze (320); oder

teilchenstrahlinduziertes Erzeugen und / oder Bearbeiten eines Whiskerbereichs (340) oberhalb des Sockelbereichs (330) der Sondenspitze (320) und eines Mittelbereichs zwischen Sockelbereich (330) und Whiskerbereich (340) der Sondenspitze (320), wobei die seitliche Oberfläche des Mittelbereichs nicht negativ gekrümmt ist.

5. Verfahren nach der vorhergehenden Ausführungsform, wobei der Sockelbereich (330) kontinuierlich in den Whiskerbereich (340) oder in den Mittelbereich der Sondenspitze (320) übergeht, ohne dass die Krümmung der seitlichen Oberfläche der Sondenspitze (320) positiv wird.

6. Verfahren nach einer der vorhergehenden Ausführungsformen 4 - 5, wobei der Whiskerbereich (340) eine Höhe von zumindest 10 nm, bevorzugt von zumindest 50 nm, mehr bevorzugt von zumindest 100 nm, noch mehr bevorzugt von zumindest 500 nm und am meisten bevorzugt von zumindest 1000 nm aufweist; und wobei der Whiskerbereich (340) einen mittleren Radius von höchstens 30 nm, bevorzugt von höchstens 20 nm, mehr bevorzugt von höchstens 10 nm, noch mehr bevorzugt von höchstens 5 nm und am meisten bevorzugt von höchstens 3 nm aufweist.

7. Verfahren nach einer der vorhergehenden Ausführungsformen, wobei der Sockelbereich (330) eine Höhe von zumindest 20 nm, bevorzugt von zumindest 100 nm, mehr bevorzugt von zumindest 250 nm, noch mehr bevorzugt von zumindest 500 nm und am meisten bevorzugt von zumindest 1000 nm aufweist und wobei dasjenige Ende des Sockelbereichs (330), das auf dem Substrat (310) angeordnet ist, einen mittleren Radius von zumindest 25 nm, bevorzugt von zumindest 100 nm, mehr bevorzugt vom zumindest 300 nm, noch mehr bevorzugt von zumindest 750 nm und am meisten bevorzugt von zumindest 1500nm aufweist.

8. Verfahren nach einer der vorhergehenden Ausführungsformen, wobei eine der Hauptkrümmungen der Oberfläche des Sockelbereichs (330) der Sondenspitze (320) negativ und im Wesentlichen konstant ist.

9. Verfahren nach der vorhergehenden Ausführungsform, wobei die negative Hauptkrümmung der Oberfläche des Sockelbereichs (330) zumindest 1/(1000 nm), bevorzugt zumindest 1/(500 nm), mehr bevorzugt 1/(100 nm) und am meisten bevorzugt zumindest 1/(10 nm) beträgt, dabei bevorzugt jedoch höchstens den Kehrwert der Höhe des Sockelbereichs.

10. Verfahren nach einer der vorhergehenden Ausführungsformen, wobei die Wechselwirkungsposition (410) des Teilchenstrahls derart gesteuert wird, dass der Sockelbereich (330) und / oder der Mittelbereich der Sonde Schicht für Schicht erzeugt werden, wobei der Teilchenstrahl je Schicht entlang von im Wesentlichen ellipsenförmigen, bevorzugt kreisförmigen, Flächen (420) gesteuert wird.

11. Verfahren nach der vorhergehenden Ausführungsform, wobei zumindest eine Halbachse der ellipsenförmigen Flächen (420) eine Funktion der Höhendifferenz zwischen der zugehörigen Schicht und der Oberfläche des Substrats (310) ist, wobei die Funktion einen Abschnitt einer Ellipse, insbesondere eines Kreises, beschreibt.

12. Verfahren nach einer der vorhergehenden Ausführungsformen, wobei das teilchenstrahlinduzierte Erzeugen und / oder Bearbeiten der Sondenspitze (320) während des Herstellens der Sonde (300) für eine bestimmbare Zeitdauer, bevorzugt für höchstens 1000 ms, mehr bevorzugt für höchstens 500 ms und am meisten bevorzugt für höchstens 50 ms zumindest einmal unterbrochen wird.

13. Verfahren nach einer der vorhergehenden Ausführungsformen, ferner umfassend den Schritt des: Justieren des Teilchenstrahls vor und / oder während des Herstellens der Sonde (300) basierend auf einer teilchenoptischen Messung zumindest eines Teils des Substrats (310) und / oder der Sondenspitze (320).

14. Verfahren nach der vorhergehenden Ausführungsform, wobei das Justieren des Teilchenstrahls zumindest teilweise auf zumindest einer auf dem Substrat (310) angebrachten, insbesondere darauf abgeschiedenen, Markierung (720) basiert.

15. Verfahren nach einer der vorhergehenden Ausführungsformen 13 - 14, wobei das Justieren des Teilchenstrahls zumindest einen der folgenden Schritte umfasst:

    a. Anpassen einer Fokusposition des Teilchenstrahls;
    b. Korrigieren eines Strahlfehlers des Teilchenstrahls;
    c. Korrigieren eines Astigmatismus des Teilchenstrahls;
    d. Anpassen des Teilchenflusses des Teilchenstrahls;
    e. Justieren einer Strahlblende des Teilchenstrahls; und
    f. Anpassen der mittleren kinetischen Energie der Teilchen des Teilchenstrahls.

16. Verfahren nach einer der vorhergehenden Ausführungsformen, ferner umfassend den Schritt des: elektrisches Entladen der Sonde (300), vorzugsweise durch Wechselwirkung mit Ionen aus einem Plasma.

17. Verfahren zum Herstellen von Sonden für Rastersondenmikroskope umfassend die folgenden Schritte:

    a. Bereitstellen von einem ersten und zumindest einem zweiten Substrat (535, 310);
    b. Erzeugen eines Referenzbildes des ersten Substrats (535,310);
    c. Erzeugen von zumindest einem Objektbild des zumindest zweiten Substrats (535,310);
    d. Bestimmen zumindest einer Transformation zwischen dem Referenzbild und dem zumindest einen Objektbild; und
    e. teilchenstrahlinduziertes Erzeugen und / oder Bearbeiten zumindest einer Sondenspitze (320) auf dem zumindest zweiten Substrat (535, 310) basierend auf der zumindest einen bestimmten Transformation.

18. Verfahren nach Ausführungsform 17, ferner umfassend den Schritt des:
f. Bestimmen einer Höhendifferenz zwischen dem ersten und dem zumindest zweiten Substrat (535, 310), vorzugsweise durch ein lichtoptisches Messverfahren.

19. Verfahren nach einer der vorhergehenden Ausführungsform 17 - 18, ferner umfassend den Schritt des:
automatisches Justieren eines Teilchenstrahls basierend auf zumindest einer teilchenoptischen Messung des ersten und / oder des zumindest zweiten Substrats (535, 310).

20. Verfahren nach der vorhergehenden Ausführungsform, ferner umfassend den Schritt des:
Erzeugen von zumindest einer, vorzugsweise zwei, Markierung (720) auf dem ersten und / oder zumindest zweiten Substrat (535, 310) jeweils neben der Sondenspitze (320).

21. Verfahren nach einer der vorhergehenden Ausführungsformen 19 - 20, wobei das automatische Justieren ein automatisches Justieren eines Fokus und / oder ein automatisches Korrigieren eines Astigmatismus des Teilchenstrahls umfasst.

22. Verfahren zur Herstellung einer Sonde für ein Rastersondenmikroskop mit den folgenden Schritten:

    a. Konstruieren (1010, 1020, 1030) eines Sondenspitzendesigns basierend auf einer Mehrzahl von auswählbaren Untereinheiten (1110, 1120, 1130, 1140);
    b. teilchenstrahlinduziertes Erzeugen und /oder Bearbeiten einer Sondenspitze (320) auf einem Substrat (310) zumindest teilweise basierend auf dem konstruierten Sondenspitzendesign.

23. Verfahren nach der vorhergehenden Ausführungsform, wobei das Konstruieren des Sondenspitzendesigns das Festlegen von zumindest einem Parameter von zumindest einer der auswählbaren Untereinheiten (1110, 1120, 1130, 1140) umfasst, wobei der zumindest eine Parameter zumindest eines der folgenden umfasst:

    a. eine geometrische Form der zumindest einen auswählbaren Untereinheit;
    b. eine Abmessung der zumindest einen auswählbaren Untereinheit;
    c. eine Krümmung einer Oberfläche der zumindest einen auswählbaren Untereinheit;
    d. eine Steigung einer Oberfläche der zumindest einen auswählbaren Untereinheit;
    e. ein Material der zumindest einen auswählbaren Untereinheit; und
    f. eine Dichte der zumindest einen auswählbaren Untereinheit.

24. Verfahren nach einer der vorhergehenden Ausführungsformen 22 - 23, wobei die Mehrzahl von auswählbaren Untereinheiten zumindest einen Sockelbereich (1110), zumindest einen Whiskerbereich (1130), zumindest einen Mittelbereich (1120) und zumindest eine Kappe (1140) des Sondenspitzendesigns umfasst.

25. Verfahren nach einer der vorhergehenden Ausführungsformen 22 - 24 ferner umfassend:
Computergestütztes Überprüfen, ob das Sondenspitzendesign durch teilchenstrahlinduziertes Erzeugen auf einem Substrat (310) herstellbar ist, wobei das Überprüfen zumindest eine Randbedingung des teilchenstrahlinduzierten Erzeugens und / oder Bearbeiten und / oder zumindest eine Konsistenzbedingung des Sondenspitzendesigns berücksichtigt.

26. Verfahren nach einer der vorhergehenden Ausführungsformen 22 - 25, ferner umfassend:
Steuern einer Wechselwirkungsposition (410) eines Teilchenstrahls basierend auf dem konstruierten Sondenspitzendesign.

27. Verfahren nach einer der vorhergehenden Ausführungsformen 22 - 26, wobei die Untereinheiten (1110, 1120, 1130, 1140) jeweils mit zumindest einem der folgenden Parameter assoziiert sind:

a. einem Anwendungsbereich der Sonde;
b. einer für die Sonde spezifischen Messmethode;
c. einer für die Sonde spezifischen Art von Messobjekt;
d. einem für die Sonde spezifischem Rastermikroskop; und
e. einem Substrattyp.

28. Sonde (300) für ein Rastersondenmikroskop aufweisend:

a. ein Substrat (310) und eine auf dem Substrat (310) angeordneten Sondenspitze (320),
b. wobei eine seitliche Oberfläche eines Sockelbereichs (330) der Sondenspitze (320) eine im Wesentlichen negative Krümmung aufweist; und
c. wobei die Sonde (330) nach dem Verfahren einer der vorhergehenden Ausführungsformen hergestellt worden ist.

29. Vorrichtung zur Herstellung einer oder einer Mehrzahl von Sonden für ein Rastersondenmikroskop aufweisend:

a. Mittel zum Durchführen des Verfahrens nach einer der Ausführungsformen 1 - 27; und
b. Mittel zum Ausführen eines Computerprograms.

30. Computerprogramm mit Anweisungen zum Durchführen eines Verfahrens nach einer der Ausführungsformen 1 - 27 mit der Vorrichtung nach Ausführungsform 29.

**Patentansprüche**

1. Verfahren zur Herstellung einer Sonde (300) für ein Rastersondenmikroskop mit folgenden Schritten:

a. teilchenstrahlinduziertes Erzeugen und / oder Bearbeiten einer Sondenspitze (320) auf einem Substrat (310);
b. wobei eine sich zeitlich verändernde Wechselwirkungsposition (410) eines Teilchenstrahls derart kontrolliert wird, dass eine seitliche Oberfläche eines Sockelbereichs (330) der erzeugten und / oder bearbeiteten Sondenspitze (320) eine negative Krümmung aufweist.

2. Verfahren nach dem vorhergehenden Anspruche, ferner umfassend:

teilchenstrahlinduziertes Erzeugen und / oder Bearbeiten eines Whiskerbereichs (340) oberhalb des Sockelbereichs (330) der Sondenspitze (320); oder
teilchenstrahlinduziertes Erzeugen und / oder Bearbeiten eines Whiskerbereichs (340) oberhalb des Sockelbereichs (330) der Sondenspitze (320) und eines Mittelbereichs zwischen Sockelbereich (330) und Whiskerbereich (340) der Sondenspitze (320), wobei die seitliche Oberfläche des Mittelbereichs nicht negativ gekrümmt ist.

3. Verfahren nach einem der vorhergehenden Ansprüche, wobei eine der Hauptkrümmungen der Oberfläche des Sockelbereichs (330) der Sondenspitze (320) negativ und im Wesentlichen konstant ist.

4. Verfahren nach dem vorhergehenden Anspruch, wobei die negative Hauptkrümmung der Oberfläche des Sockelbereichs (330) zumindest 1/(1000 nm), bevorzugt zumindest 1/(500 nm), , mehr bevorzugt 1/(100 nm) und am meisten bevorzugt zumindest 1/(10 nm) beträgt, dabei bevorzugt jedoch höchstens den Kehrwert der Höhe des Sockelbereichs.

5. Verfahren nach einem der vorhergehenden Ansprüche, wobei die Wechselwirkungsposition (410) des Teilchenstrahls derart gesteuert wird, dass der Sockelbereich (330) und / oder der Mittelbereich der Sonde Schicht für Schicht erzeugt werden, wobei der Teilchenstrahl je Schicht entlang von im Wesentlichen ellipsenförmigen, bevorzugt kreisförmigen, Flächen (420) gesteuert wird; und / oder wobei das teilchenstrahlinduzierte Erzeugen und / oder Bearbeiten der Sondenspitze (320) während des Herstellens der Sonde (300) für eine bestimmbare Zeitdauer, bevorzugt für höchstens 1000 ms, mehr bevorzugt für höchstens 500 ms und am meisten bevorzugt für höchstens 50 ms zumindest einmal unterbrochen wird.

6. Verfahren nach einem der vorhergehenden Ansprüche, ferner umfassend den Schritt des:
Justieren des Teilchenstrahls vor und / oder während des Herstellens der Sonde (300) basierend auf einer teilchenoptischen Messung zumindest eines Teils des Substrats (310) und / oder der Sondenspitze (320) und / oder den Schritt des elektrischen Entladen der Sonde (300), vorzugsweise durch Wechselwirkung mit Ionen aus einem Plasma.

7. Verfahren nach dem vorhergehenden Anspruch, wobei das Justieren des Teilchenstrahls zumindest teilweise auf zumindest einer auf dem Substrat (310) angebrachten, insbesondere darauf abgeschiedenen, Markierung (720) basiert; und / oder wobei das Justieren des Teilchenstrahls zumindest einen der folgenden Schritte umfasst:

a. Anpassen einer Fokusposition des Teilchenstrahls;
b. Korrigieren eines Strahlfehlers des Teilchenstrahls;
c. Korrigieren eines Astigmatismus des Teilchenstrahls;
d. Anpassen des Teilchenflusses des Teilchenstrahls;
e. Justieren einer Strahlblende des Teilchenstrahls; und
f. Anpassen der mittleren kinetischen Energie der Teilchen des Teilchenstrahls.

8. Verfahren zum Herstellen von Sonden für Rastersondenmikroskope umfassend die folgenden Schritte:

a. Bereitstellen von einem ersten und zumindest einem zweiten Substrat (535, 310);
b. Erzeugen eines Referenzbildes des ersten Substrats (535, 310);
c. Erzeugen von zumindest einem Objektbild des zumindest zweiten Substrats (535, 310);
d. Bestimmen zumindest einer Transformation zwischen dem Referenzbild und dem zumindest einen Objektbild; und
e. teilchenstrahlinduziertes Erzeugen und / oder Bearbeiten zumindest einer Sondenspitze (320) auf dem zumindest zweiten Substrat (535, 310) basierend auf der zumindest einen bestimmten Transformation.

9. Verfahren nach Anspruch 8, ferner umfassend einen oder mehrere der folgenden Schritte:

f. Bestimmen einer Höhendifferenz zwischen dem ersten und dem zumindest zweiten Substrat (535, 310), vorzugsweise durch ein lichtoptisches Messverfahren
g. automatisches Justieren eines Teilchenstrahls basierend auf zumindest einer teilchenoptischen Messung des ersten und / oder des zumindest zweiten Substrats (535, 310).
h. Erzeugen von zumindest einer, vorzugsweise zwei, Markierung (720) auf dem ersten und / oder zumindest zweiten Substrat (535, 310) jeweils neben der Sondenspitze (320).

10. Verfahren zur Herstellung einer Sonde für ein Rastersondenmikroskop mit den folgenden Schritten:

a. Konstruieren (1010, 1020, 1030) eines Sondenspitzendesigns basierend auf einer Mehrzahl von auswählbaren Untereinheiten (1110, 1120, 1130, 1140);
b. teilchenstrahlinduziertes Erzeugen und /oder Bearbeiten einer Sondenspitze (320) auf einem Substrat (310) zumindest teilweise basierend auf dem konstruierten Sondenspitzendesign.

11. Verfahren nach dem vorhergehenden Anspruch, wobei das Konstruieren des Sondenspitzendesigns das Festlegen von zumindest einem Parameter von zumindest einer der auswählbaren Untereinheiten (1110, 1120, 1130, 1140) umfasst, wobei der zumindest eine Parameter zumindest eines der folgenden umfasst:

a. eine geometrische Form der zumindest einen auswählbaren Untereinheit;
b. eine Abmessung der zumindest einen auswählbaren Untereinheit;
c. eine Krümmung einer Oberfläche der zumindest einen auswählbaren Untereinheit;
d. eine Steigung einer Oberfläche der zumindest einen auswählbaren Untereinheit;
e. ein Material der zumindest einen auswählbaren Untereinheit; und
f. eine Dichte der zumindest einen auswählbaren Untereinheit.

12. Verfahren nach einem der vorhergehenden Ansprüche 10 - 11 ferner umfassend:

Computergestütztes Überprüfen, ob das Sondenspitzendesign durch teilchenstrahlinduziertes Erzeugen auf einem Substrat (310) herstellbar ist, wobei das Überprüfen zumindest eine Randbedingung des teilchenstrahlinduzierten Erzeugens und / oder Bearbeiten und / oder zumindest eine Konsistenzbedingung des Sondenspitzendesigns berücksichtigt; und / oder Steuern einer Wechselwirkungsposition (410) eines Teilchenstrahls basierend auf dem konstruierten Sondenspitzendesign.

13. Sonde (300) für ein Rastersondenmikroskop aufweisend:

a. ein Substrat (310) und eine auf dem Substrat (310) angeordneten Sondenspitze (320),
b. wobei eine seitliche Oberfläche eines Sockelbereichs (330) der Sondenspitze (320) eine im Wesentlichen negative Krümmung aufweist; und

c. wobei die Sonde (330) nach dem Verfahren einer der vorhergehenden Ansprüche hergestellt worden ist.

14. Vorrichtung zur Herstellung einer oder einer Mehrzahl von Sonden für ein Rastersondenmikroskop aufweisend:

   a. Mittel zum Durchführen des Verfahrens nach einem der Ansprüche 1 - 12; und
   b. Mittel zum Ausführen eines Computerprograms.

15. Computerprogram mit Anweisungen zum Durchführen eines Verfahrens nach einem der Ansprüche 1 - 12 mit der Vorrichtung nach Anspruch 14.

**Fig. 1:** STAND DER TECHNIK

**Fig. 2:** STAND DER TECHNIK

**Fig. 3**

**Fig. 4**

**Fig. 5**

**Fig. 6**

**Fig. 7**

**Fig. 8**

710 740

710 740

710 740

a)

b)

c)

**Fig. 9**

1010

1020

A

B

C

1030

1040

**Fig. 10**

1140

Radius: 40 nm
Höhe: 80 nm

1130

Höhe: 300 nm

1120

Radius unten: 45 nm
Höhe: 300 nm

1110

Krümmung: 500 nm
Höhe: 300 nm

**Fig. 11**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102018221778
- DE 102016223659
- DE 19825404
- DE 10322005
- DE 102009022912
- US 7232997 B
- US 6593583 B
- EP 1662538 A
- US 6521890 B
- DE 102016115827 A1

**In der Beschreibung aufgeführte Nicht-Patentliteratur**

- **B. HÜBNER et al.** Tips for scanning tunneling microscopy produced by electron-beam-induced-deposition. *Ultramicrsocopy,* 1992, 42-44
- **J. CORTES ROSA et al.** Direct patterning of surface quantum wells with an atomic force microscope. *Appl. Phys. Lett.,* 1998, vol. 73 (18), 2684
- **J. H. KINDT ; G. E. FANTNER ; J. B. THOMPSON ; P. K. HANSMA.** Automated wafer-scale fabrication of electron beam deposited tips for atomic force microscopes using pattern recognition. *Nanotechnology,* 2004, vol. 15, 1131-1134
- **D. FREEMAN ; B. LUTHER-DAVIES ; S. MADDEN.** Real-Time Drift Correction of a Focused Ion Beam Milling System. *NSTI-Nanotech,* 2006
- **C. J. LOBO ; A. MARTIN ; M. R. PHILLIPS ; M. TOTH.** Electron beam induced chemical dry etching and imaging in gaseous NH3 environments. *Nanotechnology,* 2012, 1-7